# EUROPEAN PATENT APPLICATION

(11) **EP 1 970 347 A1**
(43) Date of publication of application: **17.09.2008**
(21) Application number: 07425151.3
(22) Date of filing: 16.03.2007
(51) Int. Cl.: B81C 5/00, B22F 1/00, C25D 11/02

(54) **Process to manufacture micro- or nanometric particles**

(71) Applicant: C.R.F. Società Consortile per Azioni, 10043 - Orbassano (Torino) (IT)
(72) Inventor: Lambertini, Vito Guido, c/o C.R.F. Società, 10043 Orbassano (Torino) (IT); Pizzi, Marco, c/o C.R.F. Società, 10043 Orbassano (Torino) (IT); Valerio, Federica, c/o C.R.F. Società, 10043 Orbassano (Torino) (IT); Grasso, Valentina, c/o C.R.F. Società, 10043 Orbassano (Torino) (IT); Alacqua, Stefano, c/o C.R.F. Società, 10043 Orbassano (Torino) (IT)
(74) Representative: Gallarotti, Franco

(57) **Abstract**

A process is described, for the production of particles of micrometric or nanometric dimensions. The process provides for the use of a sacrificial element defining a series of cavities of nanometric dimensions for the purposes of structuring a portion of the particles.

## Description

### Field of the invention

The present invention relates to a process for the production of particles of micrometric or nanometric dimensions.

### Prior art

In the sector of nanotechnologies an ever-increasing interest is dedicated to the production of particles having micrometric or nanometric dimensions. Particles of the type referred to - in what follows identified for reasons of simplicity with the term "nanoparticles" - are for example used in the nanoscale biotechnological and biomedical fields, in nano-electronics and in nanosensor technology, in the production of composite materials, special coatings, optical devices, light sources, fuel cells, etc.

In some applications, nanoparticles, which are also known as "nanobeads", are produced for the purpose of exploiting one or more characteristics proper to the material or to the composite constituting the body of the nanoparticles themselves (for example, electronic, optical, electrical, magnetic, chemical, and mechanical characteristics). In other applications, the outer surface of the body of the nanoparticles is subjected to molecular functionalization.

In the biomedical field there is known, for example, the use of superparamagnetic nanoparticles, which are functionalized for being used as vectors of ligands designed for interacting with target substances (see, for example, the document No. US 5, 916, 539). In typical use, said functionalized superparamagnetic nanoparticles are added to a specimen to be analysed and, thanks to the specific affinity of the ligands present on their surface, bind to the target (cells, nucleic acids, proteins, or other biomolecules). The nanoparticles referred to typically have a core of superparamagnetic ferrite, which makes them sensitive to the magnetic fields applied so as to enable a rapid and effective separation thereof from the rest of the solution, together with the target molecules, but without residual magnetic fields that would favour the formation of aggregates.

Irrespective of the type of application, an important parameter that characterizes nanoparticles from the functional standpoint is represented by the ratio between the active surface of the particle and its volume. By "active surface" is meant the surface of the nanoparticle that can be exploited, in the final application, to perform a given function. For example, in the case of functionalized nanoparticles, the active surface is the one that can receive the aforementioned ligands or, more in general, the one on which substances can be bound chemically. In other applications, in which the nanoparticles are not functionalized, the active surface of the particle is the one that can interact with other structures or devices or with the means in which the particle itself comes to operate, or yet again simply its exposed surface.

Nanoparticles of the type commonly used have an approximately spherical shape, with a diameter generally comprised between 100 nm and 10 µm. The substantially spherical shape bestows the advantage of rendering the particles readily manageable and of optimizing the kinetic reactions that determine the bonds with the target substances. The substantially spherical conformation fails, however, to provide the particles with an active surface sufficiently extensive with respect to their volume.

### Summary of the invention

The purpose of the present invention is basically to provide a process that will enable production of particles of micrometric or nanometric dimensions that possibly but not necessarily are to undergo functionalization, having a surface/volume ratio larger than that of particles according to the prior art.

The above purposes are achieved, according to the invention, by a process for the production of particles of nanometric or micrometric dimensions having the characteristics of Claim 1. The purposes of the invention are likewise achieved by functionalized or functionalizable particles having the characteristics appearing in Claim 16.

Preferred characteristics of the process and of the particles according to the invention are specified in the sub-claims, which, together with the independent claims, form an integral part of the technical teaching provided herein in relation to the invention.

In its essence, the idea of technical solution underlying the present invention is that of increasing the useful or active surface of particles of the type referred to by means of a process of nanostructuring, using for said purpose a sacrificial element having a porous configuration that acts as template. In this way, each nanoparticle must have a portion with a shape that is substantially complementary to that of a respective part of the sacrificial element and hence distinguished by a plurality of projections and interspaces between the projections, with an increase in the ratio between the surface and the volume of the particle with respect to the known art.

### Brief description of the drawings

Further purposes, characteristics and advantages of the present invention will emerge clearly from the ensuing detailed description and from the annexed plate of drawings, which are provided purely by way of explanatory and non-limiting example and in which:
- Figure 1 is a perspective schematic view of a portion of a film of anodized porous alumina, which can be used as sacrificial element or template in the process according to the invention;
- Figures 2 - 5 are schematic cross sections aimed at illustrating some steps of a process of formation of an alumina film of the type represented in Figure 1;
- Figures 6 - 13 are schematic cross sections that show the steps of a first example of implementation of the process according to the invention;
- Figures 14 - 21 are schematic cross sections that show the steps of a second example of implementation of the process according to the invention; and
- Figures 22 - 28 are schematic cross sections that show the steps of a third example of implementation of the process according to the invention.

### Detailed description of examples of embodiments of the invention

In what follows, possible implementation embodiments of the process will be described, which use, as sacrificial element, a film of anodized porous alumina with a high degree of regularity, which functions as template for the production of particles of micrometric or nanometric dimensions distinguished by a particular surface nanostructuring. The choice of anodized porous alumina is to be, however, considered as being provided purely by way of non-limiting example for the purposes of the present invention.

Porous alumina has a structure that can be idealized as an matrix of microchannels arranged parallel to one another. Porous alumina can be obtained via a process of anodization of sheets of aluminium of high purity or of aluminium films on substrates, such as glass, quartz, silicon, tungsten, etc.

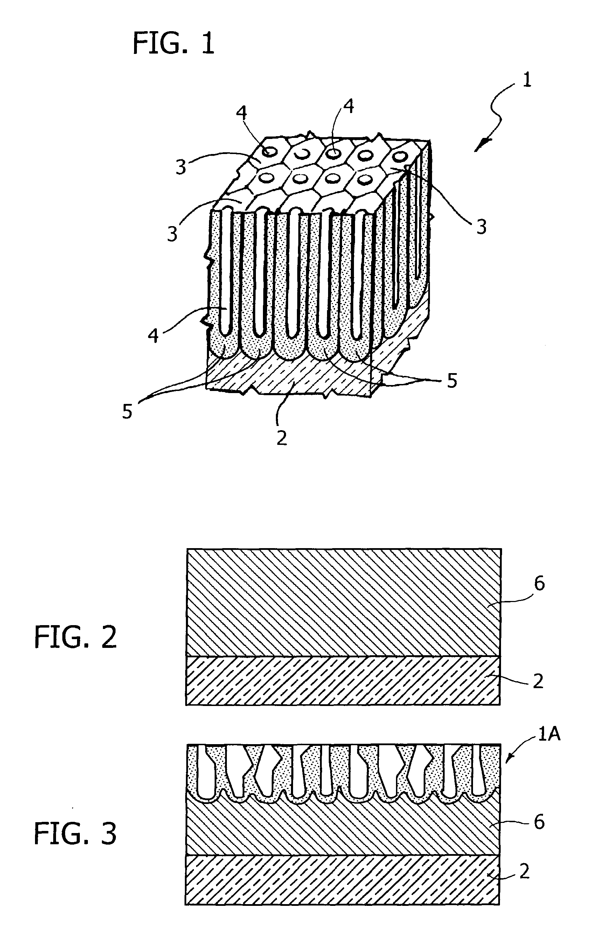

Figure 1 is a schematic illustration, provided purely by way of example, of a portion of a film of porous alumina, designated as a whole by 1, obtained via anodic oxidation of an aluminium film on a suitable substrate, the latter being designated by 2. As may be noted, the layer of alumina 1 is formed by a series of substantially hexagonal cells 3 arranged directly adjacent to one another (i.e., with a honeycomb structure), each cell having a straight central hole that forms a microchannel or blind pore 4, substantially perpendicular to the surface of the substrate 2. The end of each cell 3, which is located in an area corresponding to the substrate 2, has a closing portion presenting a substantially hemispherical geometry, the set of the closing portions forming as a whole a non-porous part of the film 1, or barrier layer, designated by 5.

The film 1 can be developed, according to the known art, with controlled morphology by appropriately choosing the electrolyte and the physical, chemical, and electrochemical parameters of the process: in acidic electrolytes (such as phosphoric acid, oxalic acid, and sulphuric acid) and in adequate process conditions (voltage, current, stirring, and temperature), it is possible to obtain porous films with a high degree of regularity. For this purpose, the dimensions and density of the cells 3, the diameter of the pores 4, and the height of the film 1 can be varied; for example, the diameter of the pores 4, which is typically comprised between 50 - 500 nm, can be widened or restricted using chemical treatments; similar considerations apply also to the depth of the pores, which can be varied between some microns and some tens of microns.

As illustrated schematically in Figure 2, a first step of the production of a film 1 of porous alumina is the deposition of a layer of aluminium 6 on the substrate 2, the latter being, for example, made of silicon or wolfram. The operation requires an deposition of materials with thicknesses ranging from 1 µm up to 30 µm. The preferred techniques of deposition of the layer 6 are thermal evaporation via e-beam and sputtering. As has been mentioned, the process of deposition is not necessary if a sheet of aluminium of high purity and with a high degree of surface quality is used directly.

The step of deposition of the layer of aluminium 6 is followed by a step of anodization of the layer itself. The process of anodization can be carried out using different electrolytic solutions according to the dimensions and depth of the pores 4 and the distance between them that is desired to obtain. Given the same electrolyte, the concentration, current density, and temperature are the parameters that have the biggest effect on the dimension of the pores 4.

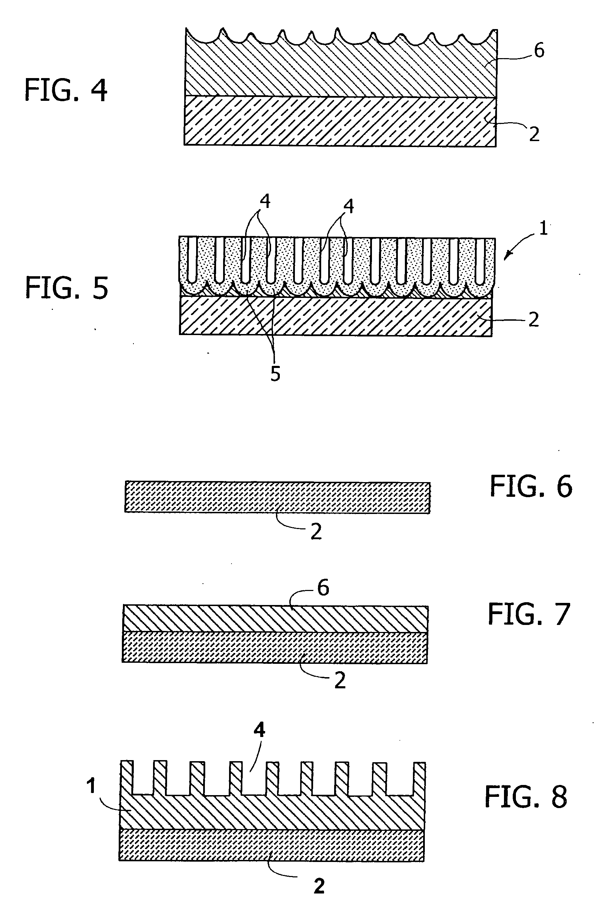

Figure 3 is a schematic illustration of the result of the first anodization of the layer of aluminium 6 on the substrate 2; the alumina film 1A, formed with the first anodization, does not enable a regular structure to be obtained. In order to obtain a regular structure, of the type like the one designated by 1 in Figure 1, it is necessary to carry out successive processes of anodization, and in particular at least:
i) a first anodization, the result of which may be seen in Figure 3;
ii) a step of reduction, via etching, of the irregular alumina film 1A, carried out using acid solutions (for example, CrO₃ and H₃PO₄) ; Figure 4 is a schematic illustration of the result of said step of etching;
iii) a second anodization of the part of the alumina film 1A that is not eliminated via etching.

The step of etching referred to in point ii) is important for defining, on the residual part of alumina 1A, preferential areas of growth of the alumina itself in the second step of anodization.

By carrying out the successive operations of etching and anodization a number of times, the structure improves until it becomes very uniform, as illustrated schematically in Figure 5, where the alumina film designated by 1 is now regular.

As will be seen in what follows, a possible implementation of the process according to the invention implies the opening of pores or microchannels 4 in the alumina film in the area of contact with the substrate. For said purpose, after the film 1 of alumina has been obtained, a step of total or localized elimination of the barrier layer 5 is carried out, for example via selective etching.

According to the invention, a regular porous film, such as an alumina film generated by means of the process described previously, is used as sacrificial template for the surface nanostructuring of micrometric or nanometric particles. More in particular, the porous film is used as base for producing, in a portion of the final particles, nanostructures that reproduce the same pattern as that of the porous film. In this way, it is possible to produce negative nanostructures, i.e., ones substantially complementary to the porous film, and hence having projections in areas corresponding to the pores 4 of the film 1.

In the first two embodiments described hereinafter, the process according to the invention is aimed at the nanostructuring of particles of superparamagnetic material, having an approximately spherical overall shape. The particles, which have a diameter roughly comprised between 0.01 and 10 µm, are principally formed by iron (preferably ferrite) or by nickel, which, being initially contained in an electrolytic solution, is deposited via a process of localized electrodeposition in aggregates of particulate form on the layer of porous material, such as the alumina film 1 obtained as described above. The process of electrodeposition is localized in specific regions thanks to the presence of a polymer matrix or mask, understood as an element that will be subsequently eliminated after the process of electrodeposition of the iron or of the nickel. The geometry of the matrix is chosen, in a way in itself known, to determine the shape and dimensions of the particles to be obtained. After elimination of the porous layer, a process of oxidation of the particles is carried out in order to induce therein a superparamagnetic nature, and the particles themselves can possibly be functionalized.

In the third embodiment described hereinafter, the process according to the invention is instead aimed at the nanostructuring of particles of basically polymeric material, such as a photopolymer or a thermoplastic polymer. Advantageously, the material in question can have a composite nature, distinguished by a polymer matrix provided with inclusions having electrical and/or magnetic and/or optical properties and/or properties of luminescence. In this case, the particles have dimensions of encumbrance, in the three dimensions, indicatively comprised between 100 nm and 10 µm. The polymerizable starting material, possibly comprising the aforesaid inclusions, is deposited in fluid form on the layer of porous material, such as the alumina film 1, obtained as described above. Next, with the mediation of a suitable mask, local polymerization of the material is induced, for the purpose of obtaining the particles. As in the previous case, the mask and the porous layer are then eliminated, and if need be, the particles are functionalized.

### First example

A first example of a process for the production of nanostructured particles according to the invention is illustrated schematically in Figures 6-13.

In this implementation, the layer of aluminium 6 is deposited, for example via thermal evaporation, on a substrate 2, made for example of silicon or else glass, as illustrated schematically in Figure 7. The step of anodization of the aluminium, described above and herein summarized schematically in Figure 8, is carried out in order to obtain a regular layer of porous alumina 1, with pores 4 closed at the bottom (note that in Figure 4, as in the subsequent figures, the geometry of the layer of alumina 1 is represented only schematically).

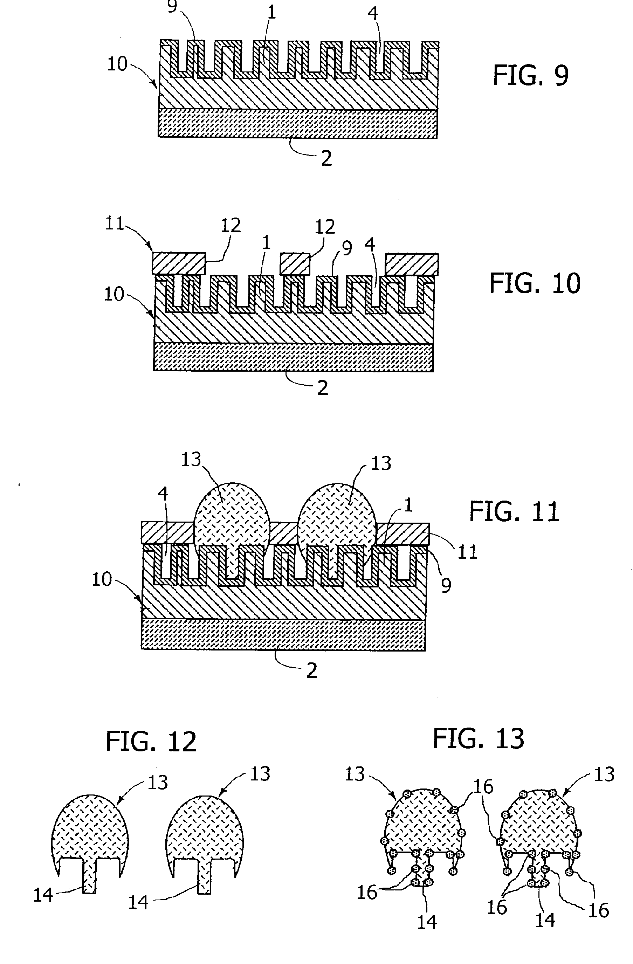

Next, as represented in Figure 9, deposited on the layer of alumina 1, for example via sputtering, is a layer 9 of electrically conductive material (for example, gold), designed to constitute an electrical contact for execution of a subsequent process of electrodeposition. The conductive layer 9 coats the top surface and the surface of the pores 4 of the layer of alumina 1 entirely. The layer of alumina 1, with the corresponding conductive layer 9, forms a sacrificial part used in the process, designated as a whole by 10.

Next (see Figure 10), deposited on top of the sacrificial part 10 is a polymeric layer 11, which will also be subsequently eliminated. The layer 11 is, for instance, deposited via spin-coating (a process of rotation that generates thin layers), and subsequently bestowed thereon is a mask or matrix structure, using a known photolithographic process (i.e., a process that involves the transfer of a drawing from a mask to a thin layer of polymeric material sensitive to radiation; a subsequent chemical etch selectively removes non-masked parts of the polymer layer).

The layer of polymeric material 11 or, more in general, of electrically insulating material, forms substantially a mask, since it has through openings 12 that define, in the sacrificial part 10, different areas of nucleation of the micrometric or nanometric particles forming the subject of the invention. Said mask 11 provides, in fact, the right spatial intervals, defined by the openings 12, to obtain regular microparticles or nanoparticles; in the covered regions of the sacrificial part 10, the mask 11 blocks, instead, nucleation of the microparticles or nanoparticles.

Figure 11 highlights two of the aforesaid areas of nucleation, in which respective particles 13 have been formed, obtained via a process of electrodeposition using an electrolytic solution containing iron. In practice, in the course of the process, the iron separates from the electrolytic solution, to accumulate in each of the aforesaid areas of nucleation, giving rise to aggregates of a substantially spherical shape. The micrometric or nanometric dimensions of the particles 13, as well as their shapes, are controlled through the physical, chemical and electrochemical parameters of the process of electrodeposition, according to techniques in themselves known.

As may be appreciated, the as a whole porous structure of the sacrificial part 10, combined with the insulating polymeric layer 11, functions as template for the lower portion of the particles 13, said lower portion thus having a shape substantially complementary to that of the porous sacrificial part 10. In particular, as illustrated in Figure 12, the particles 13 are provided with a plurality of columnar projections 14, formed by the iron atoms that have filled the pores of the sacrificial part 10, and hence with corresponding interspaces between said projections 14.

The result obtained is therefore a plurality of particles 13 that maintain a substantially spherical shape, with the advantages linked to said geometry, but that have an increased exposed surface, thanks to the presence of the aforesaid projections 14. It is to be noted that, in actual fact, the number of parallel projections 14 of the nanoparticles 13 (which depends upon the density of the pores 4 of the portion of alumina 1) may be greater than in the case represented only schematically in the figures.

After the particles 13 have been obtained, i.e., upon completion of the corresponding process of electrodeposition, the polymer mask 11 and the sacrificial part 10 are removed, for example via selective chemical etching. The particles 13 are subsequently subjected to a process of oxidation, using known procedures, to induce a superparamagnetic behaviour therein.

If need be, the particles 13 are then functionalized, also in this case with modalities in themselves known, as illustrated schematically in Figure 13. This means that, immobilized on their active surface - part of which is defined also by the columnar projections 14 - are ligands (for example, antibodies, proteins, oligonucleotides, etc.), designated as a whole by 16, i.e., any molecule designed to react with a target substance of interest.

### Second example

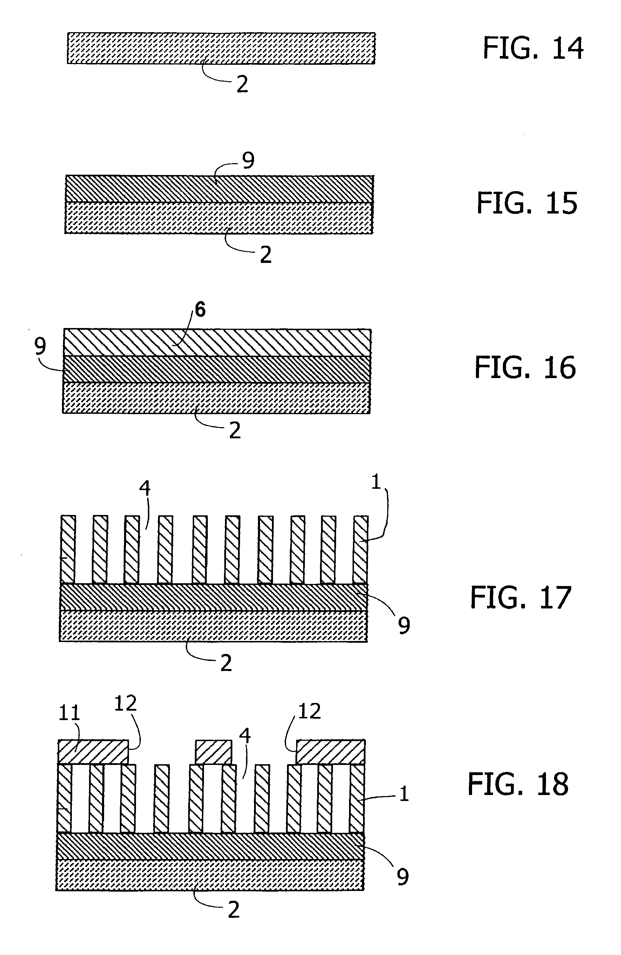

Figures 14-21 represent schematically the steps of a second example of implementation of the process according to the invention.

As may be seen in Figures 14 and 15, in this implementation the conductive layer 9 is deposited directly on the substrate 2.

Subsequently, as may be seen in Figure 16, deposited on the conductive layer 9 is the layer of aluminium 6. There is then carried out the corresponding process of anodization, to obtain a layer of porous alumina. As may be seen in Figure 17, at the end of the process of anodization, the barrier layer is eliminated, for example via selective etching, so as to obtain a film of porous alumina 1 having through pores 4, i.e., ones that open directly also out onto the conductive layer 9, which can in this way function as electrical contact or electrode for the subsequent process of electrodeposition of the metallic material to constitute the particles.

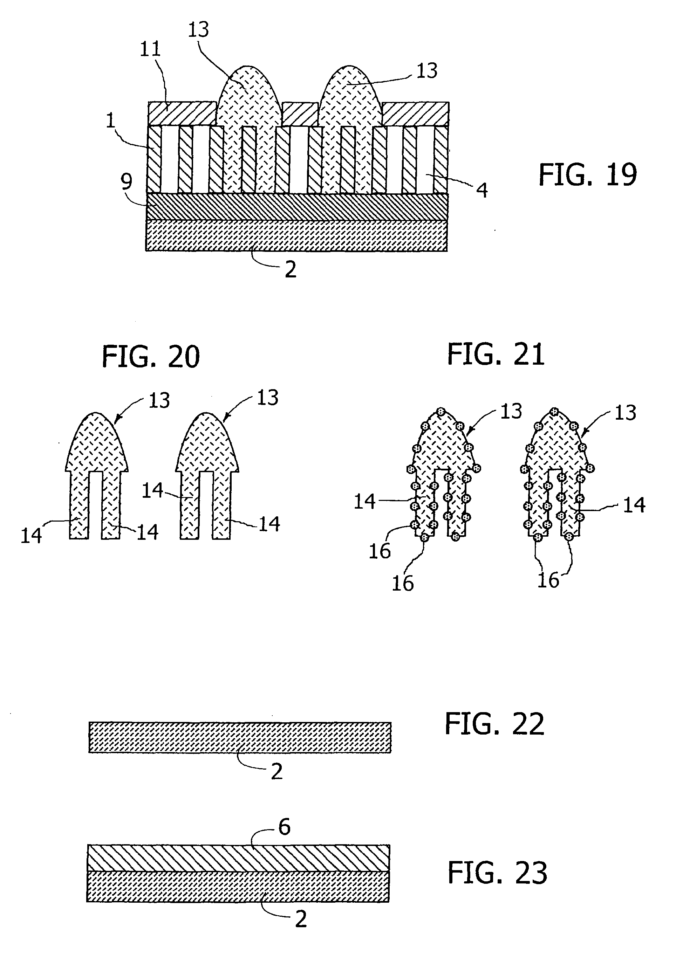

The subsequent steps of the process illustrated in Figures 18 and 19 (deposition of the polymeric mask 11 and electrodeposition of the particulate iron or nickel to obtain the corresponding aggregates that form the particles 13) correspond substantially to the ones described with reference to Figures 10 and 11 of the previous example.

As may be seen in Figure 20, the particles 13 obtained in this embodiment have, given the same thickness or height of the layer of alumina 1 as in the previous case, more axially lengthened projections 14, by virtue of the selective elimination of the barrier layer of the alumina 1. Consequently, as may be understood from a comparison between Figures 13 and 21, the active surface on which the ligands 16 can be chemically immobilized is more extensive in the case of the particles 13 obtainable with the second example of implementation, as compared to the one obtained with the first example described previously. It should, however, be noted that, alternatively, by adopting the second type of process it is possible to obtain particles 13 with active surfaces increased by the same order of magnitude as the ones obtained using the first example, but with the advantage of being able to form the sacrificial element 10 with a thinner starting layer of aluminium.

### Third example

Illustrated in Figures 22-28 is a third example of process according to the invention. Also in this case, a porous sacrificial template, and in particular an alumina film, is used for the purpose of producing particles provided with "tentacular" nanostructures, having lengths and sizes directly correlated to the diameter and depth of the pores of the aforesaid template. Also in this case techniques of a photolithographic type are used, for definition of the overall geometries at a micrometric level of the particles to be obtained, and techniques of self-assembly for definition of the nanometric structures of the particles.

The third example of process according to the invention is particularly advantageous for the purposes of nanostructuring of particles having magnetic and/or optical and/or electric characteristics, not necessarily functionalized.

The steps referred to in Figures 22-24 correspond substantially to the ones described previously with reference to Figures 6-8.

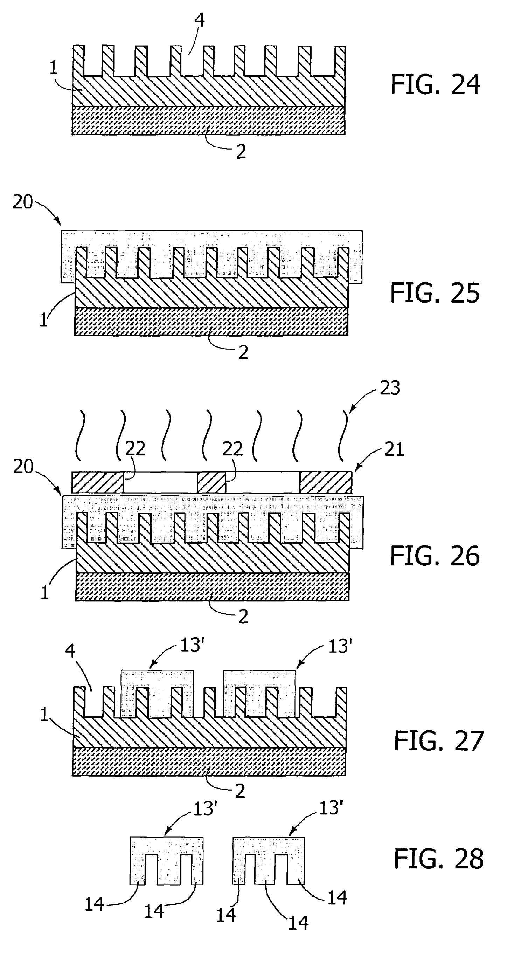

After the layer of alumina 1 has been obtained (Figure 24), deposited thereon is a layer of polymerizable material or resist, designated by 20 in Figure 25, such as a photosensitive material (for example, a photopolymer) or a thermosensitive material (for example, a thermoplastic polymer). Advantageously, the resist can contain fillers consisting of inclusions of magnetic material and/or material having optical characteristics (luminescence or colouring) and/or electrical and/or magneto-optical or electro-optical characteristics. We shall assume, in what follows, that the resist 20 is represented by a photopolymer containing fillers consisting of magnetic inclusions.

As represented in Figure 26, positioned on the ensemble, formed by the substrate 2, the sacrificial layer of alumina 1, and the resist 20, is a photolithographic mask, designated by 21, defining a series of openings or passages 22. The resist 20 is then subjected to light radiation 23, for example UV radiation, with the mediation of the mask 21. The UV radiation can reach the resist 20 only in areas corresponding to the passages 22, consequently bringing about a local polymerization thereof, the polymerized areas forming respective particles.

This step is followed by the removal of the mask 21 and of the non-polymerized part of the resist 20, as may be seen in Figure 27. Next, the alumina 1 and the corresponding substrate 2 are removed, with the release in solution of the particles, herein designated by 13', provided with the tentacular projections 14.

As already mentioned, also in the third example of embodiment, the particles 13' can possibly be subjected to surface functionalization, according to the type of application.

The above step is followed by the separation of the particles 13' from the solution in which they had been released after removal of the alumina 1 and of the substrate 2, for example via a magnet, with corresponding purification in view of its final use.

As explained previously, the material used for the production of the particles 13' can contain fillers consisting of materials having luminous-optical and/or electric characteristics.

Also in the third example of embodiment, the functionalization, when required, is obtained by immobilizing, on the surface of the particles 13', appropriate molecules, such as antibodies, proteins, oligonucleotides, or any other molecule. As for the previous examples, the choice of the molecules to be immobilized on the surface of the particles 13' depends upon the pre-selected application.

The functionalization of the particles 13, 13' can be useful for biological applications, such as for example the purification and/or separation of biological material, for the use of the particles as markers, or again for vehicling drugs or of diagnostic substances.

It should in any case be emphasized that functionalization is not always necessary and depends upon the type of material used and upon the bond that it is desired possibly to obtain (specific or non-specific). For example, if it is desired to bind a protein material in a non-specific way, the main material constituting the particles 13' can be polystyrene, which in fact presents a high non-specific affinity with proteins.

In addition to biological and biomedical applications, the particles obtainable according to the invention can of course be used in other contexts, such as the ones cited in the introductory part of the present description. It is pointed out, for example, that nanoparticles obtainable according to the invention, and in particular in accordance with the third embodiment, are advantageously usable for the production of magneto-rheological and/or electrorheological fluids, as well as for lighting up displays.

From the foregoing description, the characteristics and advantages of the invention emerge clearly. The process proposed enables nanostructured particles to be obtained, which, given the same volume or overall dimensions as the particles according to the known art, are distinguished by a decidedly increased active surface (i.e., with a greater surface/volume ratio), maintaining in any case unaltered the repeatability of dimensions and geometries and the capacity for remaining in suspension in the dilution medium provided for the final application, when envisaged.

Of course, without prejudice to the principle of the invention, the embodiments may vary with respect to what is described and illustrated herein purely by way of example.

As previously mentioned, the sacrificial element used according to the invention can comprise or be constituted by a porous film other than alumina. The materials chosen as alternatives to anodized porous alumina must preferably be easy to remove, enable selective etching necessary to free the particles from the sacrificial elements, present a regular porosity designed to enable, in the case of the first two examples of embodiment described, deposition of the polymeric layer 11 capable of defining the right geometry of nucleation of the particles themselves. Examples of materials having said characteristics, which are usable for the purposes of implementation of the invention, are for example titanium oxide and porous silicon.

## Claims

1. A process for the production of particles of micrometric or nanometric dimensions, the process being **characterized by** providing for the use of a sacrificial element (10; 1, 9; 1) defining a series of regular cavities (4) of nanometric dimensions for the purposes of nanostructuring a portion of the particles (13; 13').

2. The process according to Claim 1, wherein the structuring is aimed at the formation, in said portion of a respective particle (13; 13'), of at least one projection (14), preferably a plurality of projections (14) spatially set at a distance from one another.

3. The process according to Claim 2, wherein the sacrificial element (10; 1, 9; 1) comprises a layer of material (1) with substantially regular porosity.

4. The process according to Claim 3, wherein the sacrificial element (10; 1, 9) comprises a layer of electrically conductive material (9).

5. The process according to Claim 3, further providing for the use of a mask (11; 21), which identifies regions of formation (12; 22) of the particles (13; 13') in the sacrificial element (10; 1, 9; 1).

6. The process according to Claim 5, wherein the mask is deposited or positioned on top of the sacrificial element (10; 1, 9; 1) and is formed by a layer of electrically insulating material (11; 21).

7. The process according to Claim 3, wherein the layer with substantially regular porosity (1) is formed by at least one of anodized porous alumina, porous titanium and silicon oxide.

8. The process according to Claims 2 and 5, wherein the structuring comprises the operations of:
i) providing a material in particulate form, particularly a magnetizable metallic material;
ii) causing deposition of the particulate material in correspondence of the regions of formation (12) of the sacrificial element (10; 1, 9) identified by the mask (11), in order to form in said regions (12) aggregates of the particulate material, each region (12) including one or more of said cavities (4), which are filled by a part of the particulate material for forming the projection or projections (14) of a respective particle (13) to be obtained; and
iii) eliminating the sacrificial element (10) and the mask (11; 21), so that said particles (13) are formed by said aggregates.

9. The process according to Claims 4 and 8, wherein the particulate material is deposited in the regions of formation (12) of the sacrificial element (10) via electrodeposition, the layer made of electrically conductive material (9) functioning as electrode for the electrodeposition process.

10. The process according to Claims 3, 4, 6 and 9, wherein
- the layer of material with substantially regular porosity (1) is formed with blind pores (4), the layer of electrically conductive material (9) is deposited on the layer with substantially regular porosity (1) so as to coat at least the surface of the blind pores (4), and the layer of electrically insulating material (11) is set on a face of the layer with substantially regular porosity (1) at which the blind pores (4) open;
or else
- the layer of material with substantially regular porosity (1) is formed with through pores (4) above the layer of electrically conductive material (9), and the layer of electrically insulating material (11) is set on a face of the layer with substantially regular porosity (1) at which the through pores (4) open.

11. The process according to Claims 2 and 5, wherein the structuring comprises the operations of:
i) providing a polymerizable material (20), particularly a photopolymer or a thermoplastic polymer;
ii) depositing the polymerizable material (20) on the sacrificial element (1), so that said cavities (4) are filled by a part of the polymerizable material (20);
iii) inducing a localized polymerization of the polymerizable material (20) in correspondence of the regions of formation (22) of the sacrificial element (1) identified by the mask (21), each region (12) including one or more of said cavities (4); and
iv) removing the mask (22), eliminating the non-polymerized part of the polymerizable material (20) and eliminating the sacrificial element (10), with said particles (13') that are formed by the polymerized part of the polymerizable material (20).

12. The process according to Claim 11, wherein the polymerizable material is charged with fillers or inclusions having one or more properties selected from among magnetic properties, electrical properties, optical properties and luminescence properties.

13. The process according to at least one of Claims 8 to 10, wherein the particles are formed with a magnetizable material, particularly iron, ferrite or nickel.

14. The process according to Claim 13, further comprising an operation of oxidation of the particles (13), in such a way as to induce therein a superparamagnetic nature.

15. The process according to at least one of the preceding claims, further comprising the operation of immobilizing chemically a plurality of molecules (16) at least on the outer surface of the projection or projections (14) of said portion of the particles (13; 13').

16. Particles of micrometric or nanometric dimensions, functionalized or functionalizable, **characterized in that** they comprise a respective nanostructured portion defining a plurality of projections (14) spatially set at a distance from one another and arranged according to a substantially predefined geometry, in particular substantially parallel to one another.

17. The nanoparticles according to Claim 16, **characterized in that** they have a superparamagnetic nature.

18. The nanoparticles according to Claim 16, **characterized in that** they comprise inclusions having magnetic characteristics and/or electrical characteristics and/or optical characteristics and/or luminescence characteristics.
